# EUROPÄISCHE PATENTSCHRIFT

(11) **EP 1 114 471 B1**
(45) Veröffentlichungstag und Bekanntmachung des Hinweises auf die Patenterteilung: **04.05.2005**
(21) Anmeldenummer: 99932598.8
(22) Anmeldetag: 02.08.1999
(51) Int. Cl.: H01L 39/24, H01L 39/16

(54) **ELEKTRISCH STABILISIERTER DÜNNSCHICHT-HOCHTEMPERATURSUPRALEITER SOWIE VERFAHREN ZUR HERSTELLUNG EINES SOLCHEN SUPRALEITERS**
ELECTRICALLY STABILIZED THIN-FILM HIGH-TEMPERATURE SUPERCONDUCTOR AND METHOD FOR THE PRODUCTION THEREOF
SUPRACONDUCTEUR A HAUTE TEMPERATURE ET A COUCHE MINCE ELECTRIQUEMENT STABILISE, ET PROCEDE DE FABRICATION DUDIT SUPRACONDUCTEUR

(30) Priorität: 14.08.1998 DE 19836860
(43) Veröffentlichungstag der Anmeldung: 11.07.2001
(73) Patentinhaber: ABB RESEARCH LTD., 8050 Zürich (CH)
(72) Erfinder: PAUL, Willi, CH-5430 Wettingen (CH); CHEN, Makan, CH-5405 Baden-Dättwil (CH)
(74) Vertreter: ABB Patent Attorneys
(86) Internationale Anmeldenummer: PCT/CH1999/000359
(87) Internationale Veröffentlichungsnummer: WO 2000/010208

(56) Entgegenhaltungen:
- EP-A- 0 312 015
- EP-A- 0 339 801
- EP-A- 0 488 717
- PATENT ABSTRACTS OF JAPAN vol. 016, no. 180 (C-0935), 30. April 1992 (1992-04-30) & JP 04 021597 A (CHIYOUDENDOU HATSUDEN KANREN KIKI ZAIRYO GIJUTSU KENKYU KUMIAI), 24. Januar 1992 (1992-01-24)

## Beschreibung

### TECHNISCHES GEBIET

Die vorliegende Erfindung bezieht sich auf das Gebiet der technischen Anwendung von Hochtemperatursupraleitem (HTS). Sie betrifft einen elektrisch stabilisierten Dünnschicht-Hochtemperatursupraleiter, umfassend eine supraleitende Schicht, welche auf ein flächiges metallisches Substrat aufgebracht ist. Ein solcher Dünnschicht-HTS ist z.B, aus dem Artikel von K. Hasegawa et al., In-plane Aligned YBCO Thin Film Tape Fabricated by Pulsed Laser Deposition, International Symposium on Superconductivity (ISS '96), Sapporo, Oct. 21-24 (1996), p. 745-748, bekannt.

Sie betrifft weiterhin ein Verfahren zur Herstellung eines solchen HTS.

### STAND DER TECHNIK

Für die zuverlässige Anwendung von Hochtemperatursupraleitem (HTS) bei hohen elektrischen Leistungen, wie z.B. in einem Kurzschluss-Strombegrenzer (Fault Current Limiter FCL), ist es wesentlich, für den Supraleiter einen zuverlässigen elektrischen Bypass vorzusehen, der die Bildung von sogenannten "hot spots" verhindert, die beim Quenchen des Supraleiters aufgrund von herstellungsbedingten Materialinhomogenitäten auftreten und die Funktion des Bauelements beeinträchtigen können. Ein solcher Bypass in Form einer auf die HTS-Schicht flächig aufgebrachten Schicht aus Au oder Ag wird in dem Artikel von B. Gromoll et al., Resistive Current Limiter with YBCO Films, IEEE Transactions on Applied Superconductivity, Vol.7, 1997, p. 828-831, beschrieben.

Der Bypass soll die Spannungsverteilung homogenisieren, indem er als alternativer Hochstrompfad funktioniert, wenn der HTS quencht. Auf diese Weise kann die Bildung von "hot spots" vermieden werden. Die minimalen Anforderungen an einen solchen Bypass sind (1) ein guter elektrischer Kontakt zum HTS und (2) eine ausreichende thermische Kapazität, um den Temperaturanstieg zu begrenzen.

In der eingangs genannten Druckschrift ist ein Verfahren beschrieben worden, wie eine qualitativ hochwertige dünne Schicht grosser Länge aus Y-123 (YBCO) auf ein typisches metallisches Substrat (z.B. aus Hastelloy) mittels PLD (Pulsed Laser Deposition) aufgebracht werden kann. Allerdings ist in diesem Fall eine Trennschicht (buffer layer) aus z.B. Yttrium-stabilisiertem Zirkoniumdioxid (YSZ) zwischen dem Substrat und dem HTS vorgesehen, um die Oxidation des Substrats und die chemische Reaktion zwischen beiden Schichten zu verhindern. Es besteht daher kein elektrische Kontakt zwischen dem HTS und dem darunterliegenden Substrat, das grundsätzlich als elektrischer Bypass gut geeignet wäre.

### DARSTELLUNG DER ERFINDUNG

Es ist daher Aufgabe der Erfindung, einen elektrisch stabilisierten Dünnschicht-Hochtemperatursupraleiter zu schaffen, bei dem das tragende Substrat als elektrischer Bypass eingesetzt wird, sowie ein Verfahren zu dessen Herstellung anzugeben.

Die Aufgabe wird bei einem HTS der eingangs genannten Art dadurch gelöst, dass die supraleitende Schicht über eine auf der dem Substrat abgewandten Seite der supraleitende Schicht aufgebrachte flächige Leitschicht über die Fläche des Substrats verteilt mit dem Substrat in elektrischem Kontakt steht. Durch den über die Fläche verteilten Kontakt zwischen HTS-Schicht und darunterliegendem metallischen Substrat werden über die Fläche verteilt viele Bypasswege für den Strom geschaffen, die jederzeit die Bildung von "hot spots" an einer beliebigen Stelle des Elementes verhindern können.

Eine erste bevorzugte Ausführungsform zeichnet sich dadurch aus, dass in der supraleitenden Schicht und in der darunterliegenden Trennschicht über die Fläche verteilt Kontaktieröffnungen angeordnet sind, welche das darunterliegende Substrat freilegen, dass die Leitschicht im Bereich der Kontaktieröffnungen kontaktierend auf das freiliegende Substrat geführt ist, und dass die Kontaktieröffnungen durch Abtragen der supraleitenden Schicht bzw. der Trennschicht erzeugt sind. Die Anzahl und Verteilung der Kontaktieröffnungen kann dabei durch herkömmliche maskierte Aetzverfahren so optimiert werden, dass "hot spots" durch das als Bypass wirkende Substrat sicher verhindert werden, ohne dass der für den Stromtransport zur Verfügung stehende Querschnitt unnötig verringert wird.

Eine zweite bevorzugte Ausführungsform ist dadurch gekennzeichnet, dass die Kontaktieröffnungen durch ein Abdecken bzw. Abschatten beim Auftragen der supraleitenden Schicht bzw. der Trennschicht erzeugt sind. In diesem Fall kann auf zusätzliche Maskierungs- und Aetzschritte bei der Erzeugung der Kontaktieröffnungen verzichtet werden.

Eine erste bevorzugte Ausführungsform des erfindungsgemässen verfahrens geht davon aus, dass in einem ersten Schritt auf das metallische Substrat vollflächig eine elektrisch isolierende Trennschicht aufgebracht wird, dass in einem zweiten Schritt auf die elektrisch isolierende Trennschicht vollflächig die supraleitende Schicht aufgebracht wird, dass in einem dritten Schritt, vorzugsweise durch ein maskiertes Aetzverfahren, an verschiedenen Stellen der Fläche Kontaktieröffnungen in den beiden aufgebrachten Schichten erzeugt werden, durch welche Kontaktieröffnungen das Substrat von oben frei zugänglich ist, und dass in einem vierten Schritt vollflächig eine Leitschicht aufgebracht wird, welche die supraleitende Schicht flächig kontaktiert und durch die Kontaktieröffnungen mit dem freiliegenden Substrat verbindet.

Eine zweite Ausführungsform des erfindungsgemässen verfahrens ist dadurch gekennzeichnet, dass auf ein metallisches Substrat, welches mit über die Fläche verteilt angeordneten Gruben versehen ist, in einem ersten Schritt durch ein gerichtetes Auftragen aus einer ersten Richtung flächig eine elektrisch isolierende Trennschicht auf das Substrat aufgebracht wird, wobei die erste Richtung so gewählt ist, dass durch Abschattung die Böden der Gruben teilweise unbedeckt bleiben und Kontaktieröffnungen bilden, dass in einem zweiten Schritt durch ein gerichtetes Auftragen aus der ersten Richtung auf die elektrisch isolierende Trennschicht die supraleitende Schicht aufgebracht wird, und dass in einem dritten Schritt vollflächig eine Leitschicht aufgebracht wird, welche die supraleitende Schicht flächig kontaktiert und durch die Kontaktieröffnungen auf den Böden der Gruben mit dem freiliegenden Substrat verbindet.

Weitere Ausführungsformen ergeben sich aus den abhängigen Ansprüchen.

### KURZE ERLÄUTERUNG DER FIGUREN

Die Erfindung soll nachfolgend anhand von Ausführungsbeispielen im Zusammenhang mit der Zeichnung näher erläutert werden. Es zeigen
- Fig. 3A-F: verschiedene Schritte beim Herstellen eines Dünnschicht-HTS gemäss einem ersten, bevorzugten Ausführungsbeispiel der Erfindung, bei welchen die Kontaktierung zwischen HTS-Schicht und Substrat über lokale, durch Abtragen geöffnete Kontaktieröffnungen erfolgt; und
- Fig. 4A-D: verschiedene Schritte beim Herstellen eines Dünnschicht-HTS gemäss einem zweiten, bevorzugten Ausführungsbeispiel der Erfindung, bei welchen die Kontaktierung zwischen HTS-Schicht und Substrat über lokale, durch Abdecken bzw. Abschatten offen gelassene Kontaktieröffnungen erfolgt.

### WEGE ZUR AUSFÜHRUNG DER ERFINDUNG

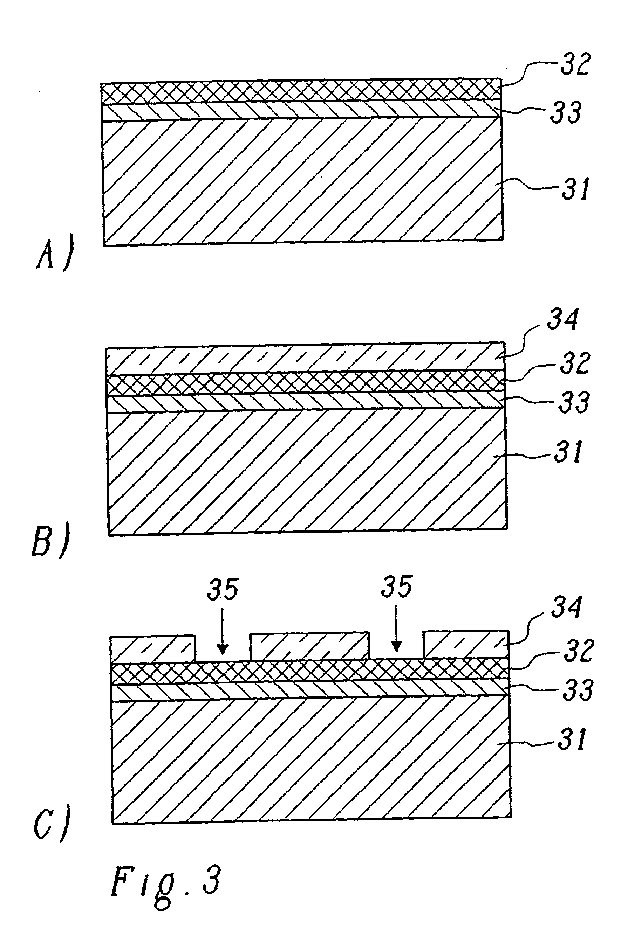

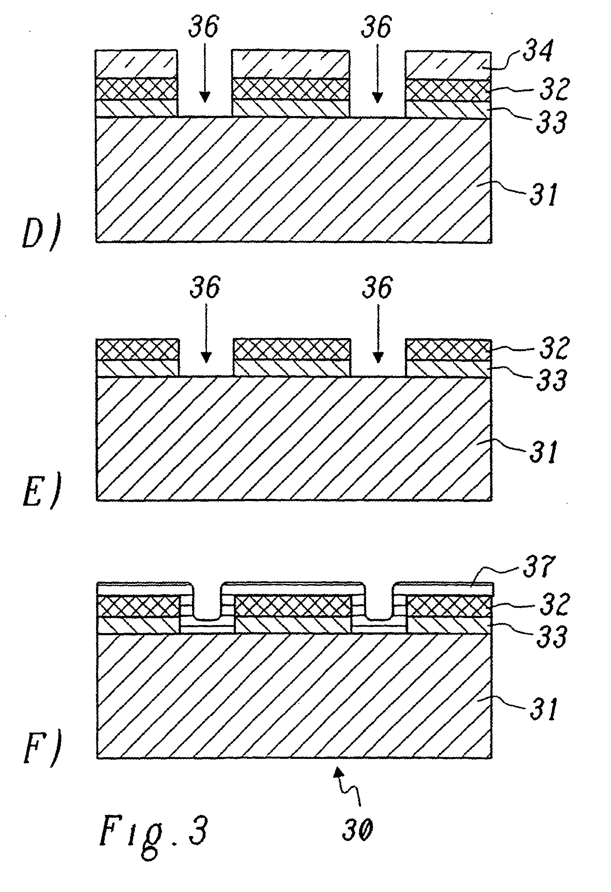

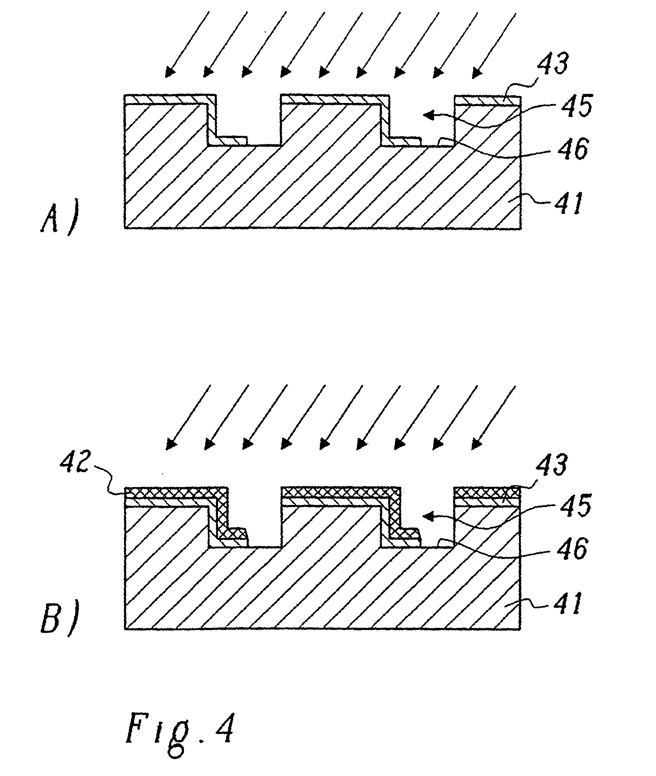

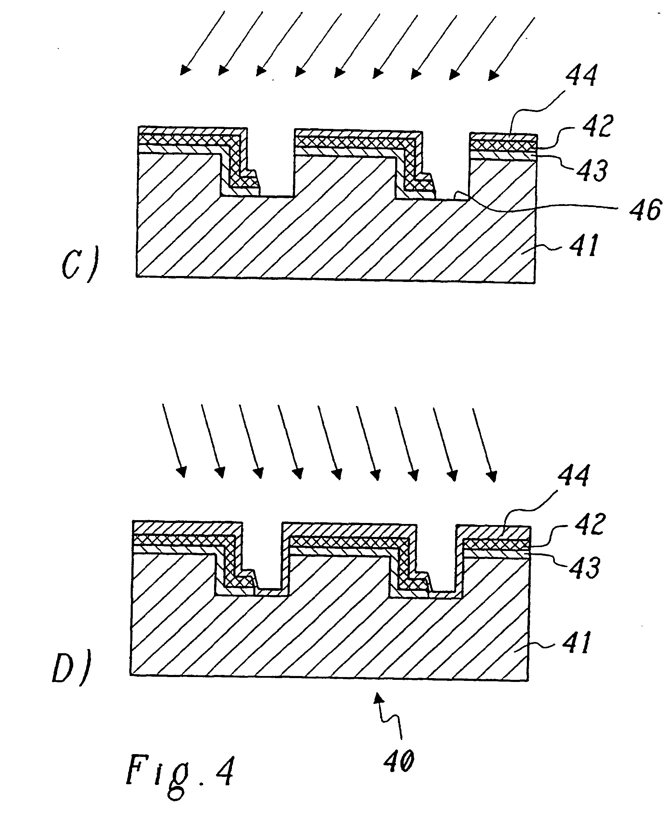

Besonders günstig ist es, wenn man die bewährten Trennschichten zur Verhinderung von Reaktionen zwischen der supraleitenden Schicht und ihren Substrat (Bufferschichten) wie z.B. das eingangs erwähnte, nichtleitende YSZ, verwenden kann ohne auf die Vorteile des als Bypass eingesetzten Substrats verzichten zu müssen. Zwei Beispiele einer solchen Lösung sind in den Fig. 3A-F und 4A-D wiedergegeben, wobei die einzelnen Teilfiguren jeweils bestimmte Schritte bei deren Herstellung bezeichnen.

Das bevorzugte Ausführungsbeispiel der Fig. 3 geht aus von einem metallischen Substrat 31, auf dessen Oberfläche nacheinander eine Trennschicht 33 (z.B. aus YSZ oder CeO oder Y₂O₃) und die eigentliche supraleitende Schicht 32 (z.B. aus YBCO) mit den bekannten, in den eingangs genannten Druckschriften beschriebenen Verfahren aufgebracht sind (Fig. 3A). Auf diese Schichtenfolge wird anschliessend eine Maskenschicht 34 aus einem geeigneten Photoresist oder dgl. aufgebracht (Fig. 3B) und anschliessend dadurch strukturiert, dass über die Fläche gleichmässig verteilt Maskenöffnungen 35 in der Maskenschicht 34 geöffnet werden (Fig. 3C).

Durch diese Maskenöffnungen 35 hindurch werden anschliessend durch ein übliches Materialabtragverfahren wie z.B. Sputterätzen die beiden darunterliegenden Schichten 32 (supraleitende Schicht) und 33( Trennschicht) abgetragen, so dass Kontaktieröffnungen 36 entstehen, durch welche die Oberfläche des Substrats 31 frei zugänglich ist (Fig. 3D). Nach dem Entfernen der Maskenschicht 34 (Fig. 3E) wird anschliessend zur Fertigstellung des Dünnschicht-Hochtemperatursupraleiters 30 ganzflächig eine Leitschicht 37 (z.B. aus Ag oder Au) aufgetragen (Fig. 3F), die ausserhalb der Kontaktieröffnungen 36 die supraleitende Schicht 32 ganzflächig kontaktiert, und innerhalb der Kontaktieröffnungen 37 elektrisch leitend mit dem Substrat 31 verbindet Es versteht sich von selbst, dass die Grösse der Kontaktieröffnungen 36 so gewählt werden muss, dass eine ausreichende Kontaktierung des Substrats 31 möglich ist. Andererseits muss die Anzahl und Verteilung der Kontaktieröffnungen 36 so gewählt werden, dass für jeden Bereich der supraleitenden Schicht 32 eine ausreichende Bypassfunktion durch das punktuell kontaktierte Substrat 31 gewährleistet ist.

Ein punktuell kontaktiertes Substrat wird auch in dem Ausführungsbeispiel gemäss Fig. 4 eingesetzt. Dazu wird von einem metallischen Substrat 41 ausgegangen, in welchem über die zu beschichtende Fläche gleichmässig verteilt Vertiefungen in Form von Gruben 45 mit vorzugsweise senkrechten Seitenwänden angeordnet sind (Fig. 4A). Auf die zu beschichtende Oberfläche des Substrats 41 wird nun in einem ersten Schritt durch ein gerichtetes Auftragen aus einer ersten Richtung (Pfeile in Fig. 4A) flächig eine elektrisch isolierende Trennschicht 43 aufgebracht. Die erste Richtung ist dabei so gewählt, dass durch Abschattung durch die Seitenwände die Böden der Gruben 45 teilweise unbedeckt bleiben und Kontaktieröffnungen 46 bilden (Fig. 4A).

In einem zweiten Schritt (Fig. 4B) wird durch ein gerichtetes Auftragen aus der ersten Richtung auf die elektrisch isolierende Trennschicht 43 eine supraleitende Schicht 42 aufgebracht. Durch denselben Abschattungseffekt bleiben auch bei diesem Auftragvorgang die Kontaktieröffnungen 46 frei. In einem dritten Schritt wird dann vollflächig eine Leitschicht 44 aufgebracht, welche die supraleitende Schicht 42 flächig kontaktiert und durch die Kontaktieröffnungen 46 auf den Böden der Gruben 45 mit dem dort freiliegenden Substrat 41 elektrisch leitend verbindet. Innerhalb des dritten Schrittes wird dabei vorzugsweise in einem ersten Teilschritt durch gerichtetes Auftragen aus der ersten Richtung eine erste Leitschicht 44' aufgebracht, welche die supraleitende Schicht 42 bedeckt und die Kontaktieröffnungen 46 im wesentlichen frei lässt (Fig. 4C). In einem zweiten Teilschritt (Fig. 4D) wird dann durch gerichtetes Auftragen aus einer zweiten, von der ersten verschiedenen Richtung die erste Leitschicht 44' zur fertigen Leitschicht 44 verstärkt und gleichzeitig durch die Kontaktieröffnungen 46 mit dem Substrat 41 leitend verbunden, wodurch der Dünnschicht-Hochtemperatursupraleiter 40 in seiner endgültigen Form entsteht.

Die Kontaktieröffnungen 36, 46 beziehungsweise die Gruben 45 sind vorzugsweise in Form von Gräben parallel zur Richtung des Stromflusses ausgebildet. In den Anordnungen gemäss Fig. 3 und Fig. 4 fliesst der Strom also senkrecht zur dargestellten Schnittebene durch den Hochtemperatursupraleiter.

Insgesamt ergibt sich mit der Erfindung ein elektrisch stabilisierter Dünnschicht-Hochtemperatursupraleiter, der zur elektrischen Stabilisierung auf das metallische Substrat zurückgreift und die Auswahl unterschiedlichster Materialien für das Substrat zulässt.

### BEZUGSZEICHENLISTE

- 30,40: Dünnschicht-HTS (elektrisch stabilisiert)
- 31,41: metallisches Substrat
- 32,42: SL-Schicht
- 33,43: Trennschicht (Buffer)
- 34: Maskenschicht
- 35: Maskenöffnung
- 36,46: Kontaktieröffnung
- 37,44,44': Leitschicht
- 45: Grube

## Patentansprüche

1. Elektrisch stabilisierter Dünnschicht-Hochtemperatursupraleiter (30, 40), umfassend eine supraleitende Schicht (32, 42), welche auf ein flächiges metallisches Substrat (31, 41) aufgebracht ist, und eine zwischen der supraleitenden Schicht (32, 42) und dem Substrat (31, 41) angeordnete isolierende Trennschicht (33, 43), **dadurch gekennzeichnet, dass** auf einer der Trennschicht gegenüberliegenden Seite der supraleitenden Schicht (32, 42) eine mit der supraleitenden Schicht (32, 42) in elektrischem Kontakt stehende, flächige Leitschicht (37, 44) aufgebracht ist, und dass die Leitschicht (37, 44) an mehreren über die Fläche verteilten Stellen (36, 46) mit dem Substrat (31, 41 ) elektrisch leitend verbunden ist.

2. Dünnschicht-Hochtemperatursupraleiter nach Anspruch 1, **dadurch gekennzeichnet, dass** in der supraleitenden Schicht (32, 42) und ggf. in der darunterliegenden Trennschicht (33, 43) über die Fläche verteilt Kontaktieröffnungen (36, 46) angeordnet sind, welche das darunterliegende Substrat (31, 41) freilegen, und dass die Leitschicht (37, 44) im Bereich der Kontaktieroffnungen (36, 46) kontaktierend auf das freiliegende Substrat (31, 41) geführt ist.

3. Dünnschicht-Hochtemperatursupraleiter nach einem der Ansprüche 1 bis 2, **dadurch gekennzeichnet, dass** die supraleitenden Schicht (32, 42) aus einem keramischen Hochtemperatursupraleiter, insbesondere YBCO, besteht, und dass die Trennschicht (33, 43) aus Yttrium-stabilisiertem Zirkoniumdioxid (YSZ) oder CeO oder Y₂O₃ besteht.

4. Verfahren zum Herstellen eines elektrisch stabilisierten Dünnschicht-Hochtemperatursupraleiters (30) nach einem der Ansprüche 1 bis 3, **dadurch gekennzeichnet, dass** in einem ersten Schritt auf ein metallisches Substrat (31) vollflächig eine elektrisch isolierende Trennschicht (33) aufgebracht wird, dass in einem zweiten Schritt auf die elektrisch isolierende Trennschicht (33) vollflächig die supraleitende Schicht (32) aufgebracht wird, dass in einem dritten Schritt, vorzugsweise durch ein maskiertes Aetzverfahren, an verschiedenen Stellen der Fläche Kontaktieröffnungen (36) in den beiden aufgebrachten Schichten (32, 33) erzeugt werden, durch welche Kontaktieröffnungen (36) das Substrat (31) von oben frei zugänglich ist, und dass in einem vierten Schritt vollflächig eine Leitschicht (37) aufgebracht wird, welche die supraleitende Schicht (32) flächig kontaktiert und durch die Kontaktieröffnungen (36) mit dem freiliegenden Substrat (31) verbindet.

5. Verfahren zum Herstellen eines elektrisch stabilisierten Dünnschicht-Hochtemperatursupraleiters (40) nach einem der Ansprüche 1 bis 3, **dadurch gekennzeichnet, dass** auf ein metallisches Substrat (41) welches mit über die Fläche verteilt angeordneten Gruben (45) versehen ist, in einem ersten Schritt durch ein gerichtetes Auftragen aus einer ersten Richtung flächig eine elektrisch isolierende Trennschicht (43) auf das Substrat (41) aufgebracht wird, wobei die erste Richtung so gewählt ist, dass durch Abschattung die Böden der Gruben (45) teilweise unbedeckt bleiben und Kontaktieröffnungen (46) bilden, dass in einem zweiten Schritt durch ein gerichtetes Auftragen aus der ersten Richtung auf die elektrisch isolierende Trennschicht (43) die supraleitende Schicht (42) aufgebracht wird, und dass in einem dritten Schritt vollflächig eine Leitschicht (44) aufgebracht wird, welche die supraleitende Schicht (42) flächig kontaktiert und durch die Kontaktieröffnungen (46) auf den Böden der Gruben (45) mit dem freiliegenden Substrat (41) verbindet.

6. Verfahren nach Anspruch 5, **dadurch gekennzeichnet, dass** innerhalb des dritten Schrittes in einem ersten Teilschritt durch gerichtetes Auftragen aus der ersten Richtung eine erste Leitschicht (44') aufgebracht wird, welche die supraleitende Schicht (42) bedeckt und die Kontaktieröffnungen (46) im wesentlichen frei lässt, und dass in einem zweiten Teilschritt durch gerichtetes Auftragen aus einer zweiten, von der ersten verschiedenen Richtung die erste Leitschicht (44') verstärkt und gleichzeitig durch die Kontaktieröffnungen (46) mit dem Substrat (41) verbunden wird.

## Claims

1. Electrically stabilized thin-film high-temperature superconductor (30, 40) comprising a superconductive layer (32, 42) which is applied to a flat metallic substrate (31, 41), and an insulating buffer layer (33, 43) arranged between the superconductive layer (32, 42) and the substrate (31, 41), **characterized in that**, on a side of the superconductive layer (32, 42) opposite the buffer layer, a flat conductive layer (37, 44), which is in electrical contact with the superconductive layer (32, 42), is applied, and that the conductive layer (37, 44) is electrically conductively connected to the substrate (31, 41) at a number of points (36, 46) distributed over the area.

2. Thin-film high-temperature super-conductor according to Claim 1, **characterized in that** in the superconductive layer (32, 42) and possibly in the underlying buffer layer (33, 43) contacting openings (36, 46) are arranged distributed over the area, which openings expose the underlying substrate (31, 41), and that the conductive layer (37, 44) is conducted in a contacting manner to the exposed substrate (31, 41) in the area of the contacting openings (36, 46).

3. Thin-film high-temperature superconductor according to one of Claims 1 to 2, **characterized in that** the superconductive layer (32, 42) consists of a ceramic high-temperature superconductor, especially YBCO, and that the buffer layer (33, 43) consists of yttrium-stabilized zirconium dioxide (YSZ) or CeO or Y₂O₃.

4. Method for producing an electrically stabilized thin-film high-temperature superconductor (30) according to one of Claims 1 to 3, **characterized in that** an electrically insulating buffer layer (33) is applied to the full area of a metallic substrate (31) in a first step, that the superconductive layer (32) is applied to the full area of the electrically insulating buffer layer (33) in a second step, that contacting openings (36) are generated in the two applied layers (32, 33) at various points of the area in a third step, preferably by means of a mask etching method, through which contacting openings (36) the substrate (31) is fully accessible from above, and that a conductive layer (37) which contacts the area of the superconductive layer (32) and connects it to the exposed substrate (31) through the contacting openings (36) is applied to the full area in a fourth step.

5. Method for producing an electrically stabilized thin-film high-temperature superconductor (40) according to one of Claims 1 to 3, **characterized in that**, on a metallic substrate (41) which is provided with grooves (45) arranged distributed over the area, an electrically insulating buffer layer (43) is applied to the area of the substrate (41) by means of a directed application from a first direction in a first step, the first direction being selected in such a manner that the bottoms of the grooves (45) remain partially uncovered due to shadowing and form contact openings (46), that the superconductive layer (42) is applied to the electrically insulating buffer layer (43) by means of a directed application from the first direction in a second step, and that a conductive layer (44) which contacts the area of the superconductive layer (42) and connects it to the exposed substrate (41) through the contacting openings (46) on the bottoms of the grooves (45) is applied to the full area in a third step.

6. Method according to Claim 5, **characterized in that**, within the third step, a first conductive layer (44') which covers the superconductive layer (42) and essentially leaves the contacting openings (46) exposed is applied by directed application from the first direction in a first part-step, and that the first conductive layer (44') is reinforced and, at the same time, connected to the substrate (41) through the contacting openings (46) by directed application from a second direction which differs from the first direction, in a second part-step.

## Revendications

1. Supraconducteur à haute température et à couche mince électriquement stabilisé (30, 40), comprenant une couche supraconductrice (32, 42) qui est déposée sur un substrat métallique plat (31, 41), et une couche de séparation isolante (33, 43) disposée entre la couche supraconductrice (32, 42) et le substrat (31, 41), **caractérisé en ce qu'**une couche conductrice plane (37, 44) en contact électrique avec la couche supraconductrice (32, 42) est déposée sur une face de la couche supraconductrice (32, 42) opposée à la couche de séparation, et que la couche conductrice (37, 44) est reliée de manière électro-conductrice avec le substrat (31, 41) en plusieurs emplacements (36, 46) répartis sur la surface.

2. Supraconducteur à haute température et à couche mince selon la revendication 1, **caractérisé en ce que** dans la couche supraconductrice (32, 42) et le cas échéant dans la couche de séparation (33, 43) située dessous sont disposées de manière répartie sur la surface des ouvertures de contact (36, 46) qui découvrent le substrat (31, 41) situé dessous et que la couche conductrice (37, 44) est mise en contact avec le substrat (31, 41) découvert dans la zone des ouvertures de contact (36, 46).

3. Supraconducteur à haute température et à couche mince selon une des revendications 1 à 2, **caractérisé en ce que** la couche supraconductrice (32, 42) est constituée d'un supraconducteur à haute température céramique, en particulier de YBCO, et que la couche de séparation (33, 43) est constituée de dioxyde de zirconium stabilisé à l'yttrium (YSZ), de CeO ou de Y₂O₃.

4. Procédé de fabrication d'un supraconducteur à haute température et à couche mince électriquement stabilisé (30) selon l'une quelconque des revendications 1 à 3, **caractérisé en ce que**, dans une première étape, une couche de séparation électriquement isolante (33) est déposée sur toute la surface d'un substrat métallique (31), que, dans une deuxième étape, la couche supraconductrice (32) est déposée sur toute la surface de la couche de séparation électriquement isolante (33), que, dans une troisième étape, des ouvertures de contact (36) sont produites dans les deux couches déposées (32, 33), à différents emplacements dans la surface, de préférence par un procédé de gravure sous masque, le substrat (31) étant librement accessible du haut par lesdites ouvertures de contact (36), et que, dans une quatrième étape, est déposée sur toute la surface une couche conductrice (37) qui est en contact superficiel avec la couche supraconductrice (32) et reliée par les ouvertures de contact (36) avec le substrat découvert (31).

5. Procédé de fabrication d'un supraconducteur à haute température et à couche mince électriquement stabilisé (40) selon l'une quelconque des revendications 1 à 3, **caractérisé en ce que**, sur un substrat métallique (41) qui est doté de fosses (45) disposées de manière répartie sur la surface, dans une première étape, une couche de séparation électriquement isolante (43) est déposée à plat sur le substrat (41) par un dépôt orienté dans une première direction, la première direction étant choisie de telle sorte que, du fait de l'abritement, les fonds des fosses (45) restent partiellement à découvert et forment des ouvertures de contact (46), que, dans une deuxième étape, la couche supraconductrice (42) est déposée sur la couche de séparation électriquement isolante (43) par un dépôt orienté dans la première direction, et que, dans une troisième étape, est déposée sur toute la surface une couche conductrice (44) qui est en contact superficiel avec la couche supraconductrice (42) et reliée par les ouvertures de contact (46) sur les fonds des fosses (45) avec le substrat découvert (41).

6. Procédé selon la revendication 5 **caractérisé en ce que** dans la troisième étape est déposée dans une première étape partielle par un dépôt orienté dans une première direction une première couche conductrice (44') qui recouvre la couche supraconductrice (42) et laisse sensiblement à découvert les ouvertures de contact (46), et que, dans une deuxième étape partielle, la première couche conductrice (44') est renforcée par un dépôt orienté dans une deuxième direction différente de la première et est en même temps reliée par les ouvertures de contact (46) avec le substrat (41).
